# EUROPEAN PATENT APPLICATION

(11) **EP 4 343 194 A1**
(43) Date of publication of application: **27.03.2024**
(21) Application number: 23173730.5
(22) Date of filing: 16.05.2023
(51) Int. Cl.: F16L 37/091, H05K 7/20, F16L 37/00

(54) **PLUG CONNECTOR DEVICE AND PLUG CODING SYSTEM**

(30) Priority: 25.05.2022 GB 202207718
(71) Applicant: Aptiv Technologies Limited, St. Michael (BB)
(72) Inventor: Rademacher, Falk, 51647 Gummersbach (DE)
(74) Representative: Gaunt, Thomas Derrick

(57) **Abstract**

The specification provides a connector (200) for connection between a hose and a device (550) in a fluid line of a fluid circuit, the device comprising a socket (555) for coupling with the connector. The connector comprises a connector body having a device connector plug (250) and comprises a channel (260) formed axially through the connector body between a distal end opening and a proximal end opening, the channel defining a fluid pathway. The connector further comprises a collar (230) arranged at a proximal end of the plug. The plug is configured to be receivable in a socket of the device, the device interface and socket formed for conformity and for secure coupling, the plug comprising an elongated body portion extending from the collar to a distal end of the connector. The plug comprising a seal (280) and a fastener (270) for engaging with the socket. Also provided is a connector and socket pair coding system for providing a coded connection between one or more connectors (200) and one or more device sockets (555) in a fluid circuit.

## Description

### Field

The present application relates in general to a dual interface connector and to a plug coding system for connecting plugs to a device.

### Background

Connecting plugs often include screw-in or screw-on variants. Such connecting plugs may be used to provide connections for systems such as cooling and heating line systems.

Screw-in connectors typically require a high level of manufacturing effort to introduce the thread on the plug and device. Screw-in connectors are typically made of aluminium so as to maintain the preload. Screw-on connector variants are often made of a less expensive plastic, however in use sockets made of metal are often required to maintain the preload. The use of screws as part of the assembly process results in additional installation space and effort requirements.

Therefore, there is a need to provide an improved connecting plug attachment means that is easily attachable to a device such that the configuration for each of attachment reduces material, manufacturing and assembly costs compared to known screw variants.

### Summary

The present invention and specification aim to address the problems associated with previous connectors and connector systems and to provide an improved connector arrangement. Accordingly, there is provided a connector and a plug and socket coding system according to the independent claims. Further optional features are provided as defined in the dependent claims.

According to a first aspect, there is provided a connector for connection to a fluid heating or cooling device comprising a socket, the connector comprising:
a connector body comprising:
a channel defining a fluid pathway between an inlet and an outlet;
a plug receivable in the socket of the device and formed for conformity with the socket and for secure coupling thereto, the plug comprising an elongated body portion;
a collar arranged at a proximal end of the plug;
wherein the plug comprises:
   a seal configured to engage with a corresponding portion of an internal wall of the device socket to provide a sealing engagement therebetween, when the plug is coupled to the socket;
   a fastener is configured to engage with a corresponding portion of the internal wall of the device socket to securely fasten the plug at the correct location in the device socket; and
   wherein the collar is configured to engage with the device to locate the plug relative to the socket; and
   wherein the connector (200) comprises a first connector coding member (2231) formed to conform with a corresponding first device coding member (561), wherein the device coding member is formed at a portion of the socket (555).

The connector comprises a plug, defining a device interface and also referred to as a device connector plug, configured for connection to and configured to conform with a corresponding socket of the device. The arrangement of the plug or the device interface provides for ease of connection and a secure connection between device and the plug and further the connector, with the further advantages of ease of alignment and insertion. The features of the plug including the seal and the fastener provide a secure engagement and a sealed engagement. The seal is important in the context of the fluid line arrangement. Furthermore, taking account of the conforming features and dimensions, the arrangement provides for the correct alignment of the fluid flow path of the channel of the connector and the fluid flow path with the device. In addition, the provision of a collar that engages with the device allows for correct location of the connector and avoids a loose or incorrection location and equally an overtightened or over-inserted connection. Provision of coding member assists in correct location and in speed and efficiency when coupling.

In one embodiment the plug and the socket may further be configured for a push-fitting connection.

In one embodiment, an external mating surface defined by the external peripheral surface of the plug comprises a generally straight-walled cylindrical form, wherein the seal and fastener are accommodated in recesses formed in the external peripheral surface.

The arrangements of the specification provide that the socket of the device may be formed as a straight walled cylindrical form socket for engagement with the plug that is configured for a push-fitting connection. The plug or device interface of the connector is also provided having a straight walled cylindrical form. Such a push-fit arrangement is less complex from the point of view of manufacture, than for example providing a threaded socket and threaded plug. On the basis of the configuration of each of the device interface and device socket, the engagement and coupling is by a push-fitting connection, which is also advantageous as it provides for a relatively simplified and direct connection, without a requirement for tooling or considerations of torque. The arrangement therefore provides for ease of assembly. The device interface is configured with the provision of the seal and fastener to provide for a secure and sealed engagement.

In one embodiment, the seal and the fastener may be integrally formed with the plug.

The plug or device interface of the connector includes an integral seal and fastener. The device interface is therefore provided configured directly for engagement with a socket of the device.

In one embodiment, the seal may further comprise one or more sealing elements, located spaced apart, each sealing element configured to sealingly engage with a corresponding portion of the internal wall of the socket. Further, each sealing element may be configured to provide a circumferential seal between the plug and a portion of the internal wall of the socket to seal any gap therebetween.

The plug or device interface may include one or more seals, to provide an effective seal as required. Each seal is provided in a channel formed on the plug body and protruding outwardly relative to the external mating surface as defined by the external peripheral surface of the plug. The seal is deformable and resilient and deforms to allow insertion and engagement with the socket in a circumferential engagement.

In one embodiment, the fastener may further comprise a circumferential fastener comprising resilient protruding members configured to provide a circumferential fixing engagement between the plug and a portion of the internal wall of the socket.

The resilient protruding members are preferably configured to exert a biasing force against a portion of the internal wall of the socket, wherein the force provides a resistance to pull-out of the connector from the socket.

The plug or device interface also comprises a fastening element provided located on the device interface. The fastening element is also resilient and deforms and extends to engage with the inner surface of the socket when the plug is inserted into a socket.

In one embodiment, an external mating surface defined by the external peripheral surface of the plug may further comprise at least two circumferential recesses formed therein and wherein a first sealing element is located in a first circumferential recess and wherein the fastener is located in a second circumferential recess.

The seal provided by engagement of the sealing element with the socket comprises a fluid tight seal.

In one embodiment, the device comprises a fluid cooling or a fluid heating device of a fluid circuit and wherein the connector is configured to connect an external device via a hose or pipe to the fluid cooling or heating device.

In one embodiment the connector may further comprise a dual interface connector,
wherein the connector body further comprises a second plug having an elongated body extending between a proximal end of the connector and the collar, the elongated body defining an external mating surface configured to be receivable in a socket of an interlocking hose connector of the fluid line;
wherein the first plug defining a device connector plug and the second plug defining a hose connector plug, the connector being configured for connection between a hose and a device in a fluid line of a fluid circuit, the device comprising socket for coupling with the connector; and
wherein the collar is arranged between the first plug and the second plug.

The connector may comprise a dual interface connector is provided for use in a fluid circuit system, the device having a socket for receiving the device interface of the connector. The socket and the device interface connector are formed for conformity and mating.

In one embodiment, the socket of the device may further comprise a recessed channel of generally cylindrical form, the internal peripheral surface of the channel defining a mating surface for mating with the external peripheral surface of the plug defining the device interface of the connector.

The socket and the device interface or plug are formed to have conforming dimensions and form for mating. The socket is of a generally cylindrical form straight walled form - and is advantageously easy to manufacture not requiring a thread or other features as seen in prior arrangements.

In one embodiment the collar may further comprise an external collar having a device engagement surface and wherein the device engagement surface is arranged to engage with a corresponding engagement surface of the device when the plug is located in a corresponding socket. In one arrangement, the device engagement surface of the collar may further define a stop or a locator for locating the plug in the socket.

The collar of the connector is configured to engage with the device. The collar may engage with the device at an external corresponding device engagement surface around or near the socket. The engagement surface may be external to the socket. The engagement surface may be located about or adjacent the socket. The collar clamps or abuts the device near or about the socket and advantageously provides an indication of correction location of the device interface - when it is fully received in the socket and assists in preventing an incomplete or partial engagement and any over insertion. The collar also effectively provides for the correct location of the one or more seals and fastener with the corresponding portion of the socket and for correction location and alignment of the fluid pathway define by the channel through the connector with an internal fluid channel of the device.

In one embodiment the connector may further comprise a first connector coding member formed to conform with a corresponding first device coding member, wherein the device coding member is formed at a portion of the socket.

Advantageously, the plug or device interface of the connector and the socket are configured essentially for a direct push-fitting connection for engagement. In comparison with previous arrangements each has a relatively simplified form configured for ease of connection. The twopart do not require a thread. Rather the engagement is between the essentially cylindrical form external mating surface of the device interface and the essentially cylindrical form internal mating surface of the socket. Taking account that a device and a fluid circuit may comprise multiple sockets and connectors, the sockets and connectors are further configured to include corresponding coding members. A first connector and corresponding socket include corresponding first coding members configured for mating.

In one embodiment, the device coding member may be formed at an opening portion of the socket.

The device coding member may be formed at the opening of the socket and has a shape and form for receiving the corresponding connector coding member. The socket coding member may be recessed relative to the external surface of the device. The socket coding provided between the socket and the external surface.

In one embodiment the connector coding member may be at least partially receivable in a corresponding device coding member.

The connector coding member is configured to engage or be received in the socket coding member. In one arrangement, the connector coding member may be located at the proximal end of the plug defining the device interface. In one arrangement the collar may further comprise the connector coding member.

The connector coding member may be provided integrated into the connector or adjacent to the connector.

In one embodiment the coding member may further comprise a geometric form and is located to provide a visual or tactile guide to the user to allow a user to distinguish a connector from a set of connectors.

The different coding members in a preferred arrangement, as shown in the exemplary arrangement of the drawings each have a different geometric form. In a preferred arrangement the cording members are visible and distinguishable from each other. The coding members may be configured to provide a visual and/or tactile guide for the user. If the coding members of a device socket and the relevant connector are visible, the user can identify the correct connector for assignment to a socket. If the coding members are tactile then the user will be guided by feedback when attempting to connect corresponding or non-corresponding coding members. The form of the coding member is such as to prevent an incorrect connection - e.g. of a return pipe/connector to an outlet of the device.

According to a further aspect, there is provided a connector and socket pair coding system for providing a coded connection between one or more connectors and one or more device sockets of fluid heating or cooling device in a fluid circuit, each connector being configured for coupling at a corresponding device socket for circulation of fluid in the fluid circuit via the device,
each connector comprising device connector plug for coupling to a socket of the device;
each device socket comprising a receiver for receiving a device connector plug and a socket coding member, the socket coding member of a first socket being different from a socket coding member of another socket;
wherein a first connector comprises a device connector plug and a first connector coding member corresponding to the first socket coding member of the first socket, for mating thereto;
the coding system configured such that each corresponding socket and connector comprises corresponding connector and socket coding members configured to provide correct assignment of each connector to the corresponding socket only.

A device and connector coding system advantageously provides for the correct assignment of a device connector plug of a dual interface connector to a corresponding device socket and prevents an incorrect connection. In an exemplary arrangement the device has an inlet and outlet socket, the coding system provides for correct connection for flow and return in a fluid circuit. The coding members are located so that they are visible to the user to allow selection of the required connector. The coding members are configured to be distinguishable from each other by visual inspection.

In one embodiment, the fluid circuit may be provided between an externally connectable device and the fluid heating or cooling device is a closed loop fluid circuit, and the first socket comprises a device inlet for receiving fluid returned from the externally connectable device and the second socket comprises a device outlet for circulating fluid from the device.

In one embodiment, each device socket may comprise a distal receiver portion having a generally cylindrical form for receiving a corresponding device connector plug, wherein the device connector plug is configured for engagement with the receiver portion in a push fitting engagement.

The arrangements and embodiments of the specification support a system in which the device socket and the connector are configured for push-fitting engagement. The use of the coding members to allow for distinguishing the return line connector and the flow line connector allows for a system having sockets and connectors of the same form. The arrangement supports use of a simplified form connectors and socket in comparison with previous arrangements and obviates the need for variants of device connector plugs and sockets.

In one embodiment, the device connector plug may be configured to sealingly engage with the receiver, the device connector plug comprising one or more seals that are configured to provide a circumferential seal between the device connector plug and the receiver.

In one arrangement, the device connector plug comprises a fastener for providing a circumferential fixing engagement between the device connector plug and the receiver, the fastener comprising a resilient fastener configured to exert a biasing force against the receiver.

In one embodiment, the socket coding member may be formed at a proximal portion of the socket near an opening of the socket and proximally of the receiver and wherein the socket coding member is configured to receive a corresponding connector coding member.

In one arrangement, each coding member may have a form corresponding to a geometrical shape.

In a preferred arrangement, the coding members have a form of a geometrical shape. It will be appreciated that other suitable forms may be provided. The coding members are configured to allow a user to distinguish and assign a connector to a corresponding socket based on visual or tactile feedback.

In one embodiment the device connector plug may comprise a push-in plug connector, wherein device connector plug comprises a generally cylindrical external peripheral surface defining a mating surface for mating with a generally cylindrical internal peripheral surface of the receiver.

In one embodiment the connector and socket coding system may comprise one or more connector of the types of the specification as described therein and with reference to the statements above.

According to a further aspect, there is provided a connector for connection to a fluid heating or cooling device comprising a socket, the connector comprising:
a connector body comprising:
a channel defining a fluid pathway between an inlet and an outlet;
a plug receivable in the socket of the device and formed for conformity with the socket and for secure coupling thereto, the plug comprising an elongated body portion;
a collar arranged at a proximal end of the plug;
wherein the plug comprises:
   a seal configured to engage with a corresponding portion of an internal wall of the device socket to provide a sealing engagement therebetween, when the plug is coupled to the socket;
   a fastener is configured to engage with a corresponding portion of the internal wall of the device socket to securely fasten the plug at the correct location in the device socket; and
   wherein the collar is configured to engage with the device to locate the plug relative to the socket.

According to a further aspect there is provided a fluid heating or cooling device and a dual interface connector system configured for connection in a fluid circuit to provide circulation of a fluid in a loop between an externally connectable device and the heating or cooling device, the circulation of the fluid including flow from an outlet of the heating or cooling device to the externally connected device and return to an inlet of the heating or cooling device via hoses or pipes,
the fluid heating or cooling device comprising a device inlet socket and a device outlet socket, each socket configured to receive a corresponding device connector plug connector as claimed of the above statements and the arrangements of the specification, for connection of an externally connected device to the device inlet and device outlet;
wherein each socket comprises a receiver having an internal peripheral surface of generally cylindrical form defining a mating surface for mating with an external peripheral surface of the device connector plug, each device connector plug comprising a seal and fastener configured to engage with the socket to provide a sealed and securely fastened connection therebetween when the device connector plug is received in the socket;
wherein the inlet and outlet sockets each further comprise a socket coding member, the socket coding member of the inlet socket being different from the socket coding member of the outlet socket, and wherein each of the corresponding connectors has a connector coding member corresponding to the socket coding member of the inlet or the outlet socket respectively, the socket and connector coding members being configured to provide a correct assignment of connectors to the inlet and outlet sockets.

According to the specification and claims, there is provided a fluid heating or cooling device and connector system configured for connection into a fluid circuit. The device and connectors are configured to mate. The arrangement is such as to provide an improved ease of use and improved accuracy of connection, without the requirement for multiple variants or additional tooling.

### Brief Description Of The Drawings

The following drawings are provided as an example to explain further and describe various aspects of the present disclosure:
Figures 1a and 1b are perspective views of previous connecting plug arrangements;

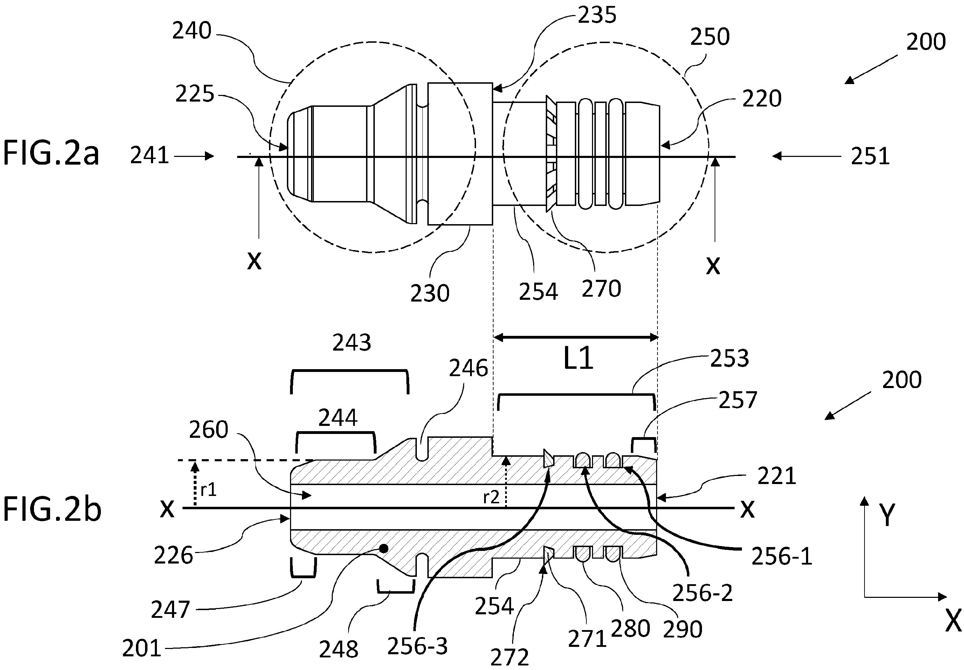

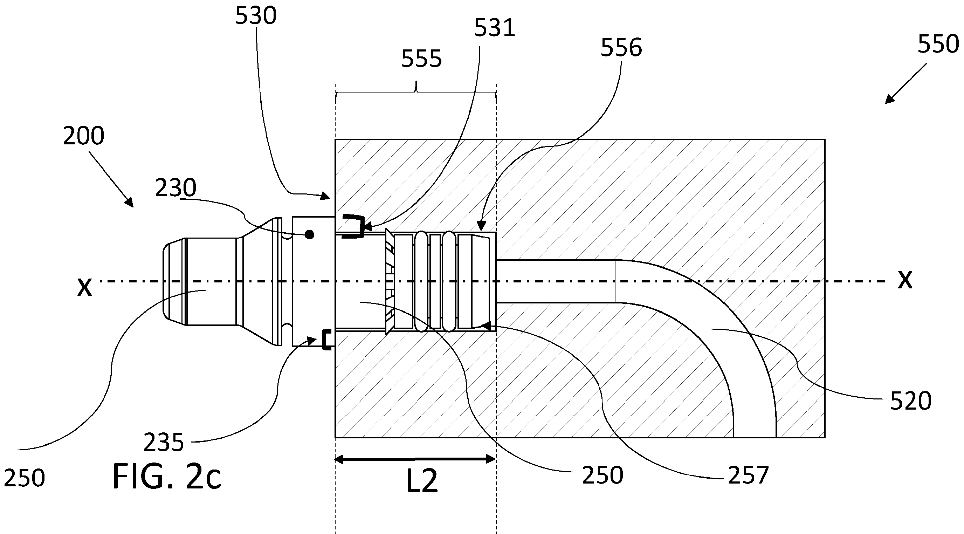

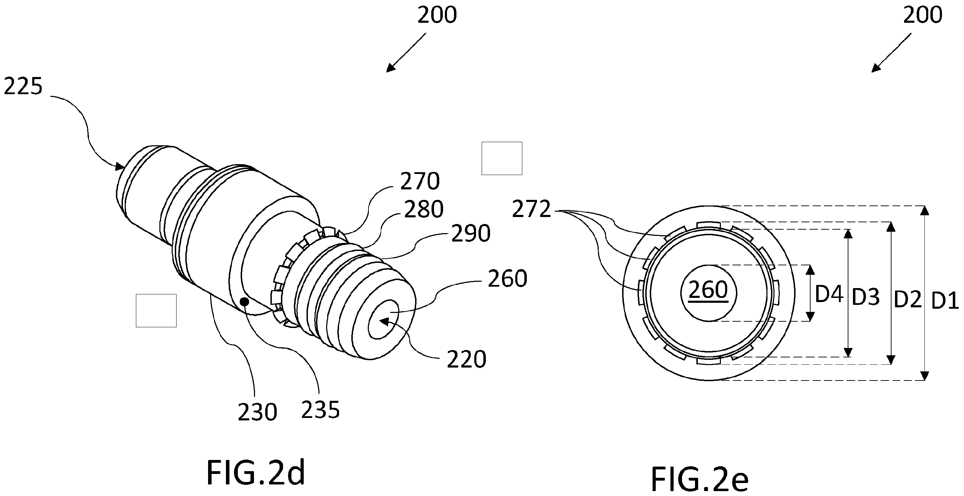

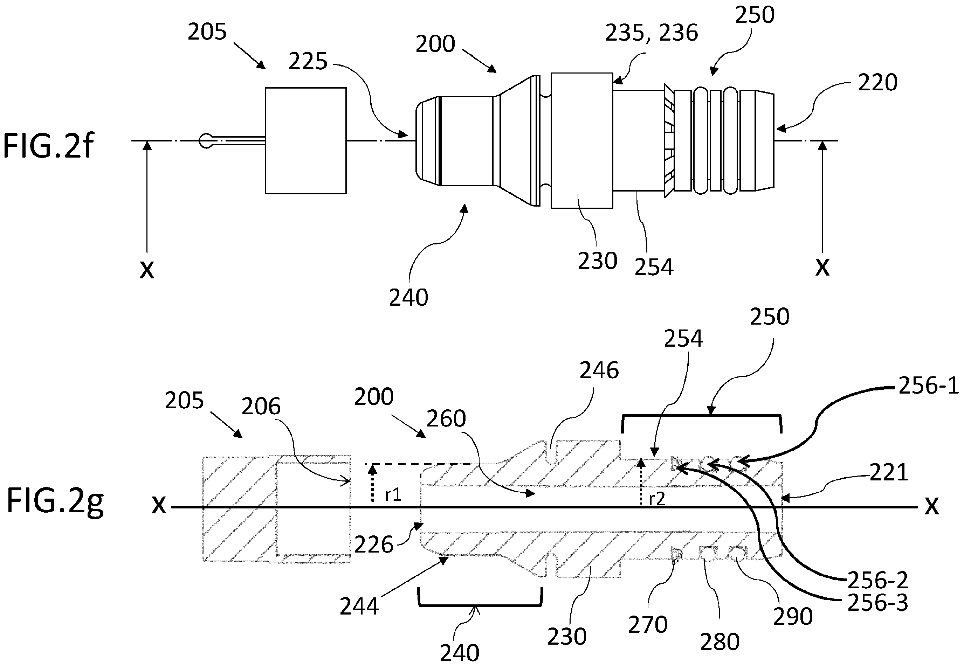

Figure 2a provides a side-view of a connecting plug according to arrangements of the present specification; Figure 2b provides a cross-sectional view of the connecting plug of figure 2a according to arrangements of the present specification; Figure 2c provides a cross sectional side view of a connecting plug positioned and secured within a device socket; Figure 2d provides a perspective view of a connecting plug according to arrangements of the present specification; Figure 2e provides a front view of the connecting plug of Figure 2d; Figure 2f provides a side-view of a connecting plug and cap according to arrangements of the present specification; Figure 2g provides a cross-sectional side-view of the connecting plug and cap of figure 2e according to arrangements of the present specification;
Figure 3a provides a side-view of an alternative connecting plug and cap according to arrangements of the present specification; Figure 3b provides a cross-sectional side-view of the alternative connecting plug and cap of figure 3a according to arrangements of the present specification;
Figure 4a provides a side-view of a hose-side connector; Figure 4b provides a side-view of a connecting plug receivable in the hose-side connector of Figure 4a according to arrangements of the present specification;
Figure 5a provides a side-view of an alternative hose-side connector; Figure 5b provides a side-view of an alternative connecting plug receivable in the hose-side connector of Figure 5a according to arrangements of the present specification;
Figure 6a provides a perspective view of the connecting plugs and a device, prior to the connecting plugs being pushed into the device; Figure 6b provides a perspective transparent view after the connecting plugs have been pushed into the device; Figure 6c provides a perspective view of the connecting plugs correctly connected at corresponding sockets; 6d provides a view of the connecting plugs incorrectly assigned and not connected at the sockets; Figures 6 e and 6f provide perspective view of the two different connector and coding members of the arrangement of Figures 6,
Figure 7a shows cross-sectional view from the side of a connector and a device having a fluid line, after the connecting plug has been pushed into the device; Figure 7b provides a side-view of the connecting plug and a device having a fluid line, after the connecting plug has been pushed into the wrong respective socket of the device;
Figure 8 provides a side-view of an alternative connecting plug according to arrangements of the present specification;
Figure 9 provides a side-view of an alternative connecting plug according to arrangements of the present specification;
Figure 10a provides a side-view of the connecting plug of Figure 9 and a device having a fluid line, after the connecting plug has been pushed into the device; Figure 10b provides a side-view of the connecting plug of Figure 9 and a device having a fluid line, after the connecting plug has been pushed into the wrong respective socket of the device;

### Detailed Description of The Drawings

The following discussion provides many exemplary embodiments of the inventive subject matter. Although each embodiment represents a single combination of inventive elements, the inventive subject matter is considered to include all possible combinations of the disclosed elements. Thus, if one embodiment comprises elements A, B, and C, and a second embodiment comprises elements B and D, then the inventive subject matter is also considered to include other remaining combinations of A, B, C, or D, even if not explicitly disclosed.

For simplicity and clarity of illustration, reference numerals may be repeated among the Figures to indicate corresponding or analogous elements. Numerous details are set forth to provide an understanding of the examples described herein. The examples may be practised without these details. In other instances, well-known methods, procedures, and components are not described in detail to avoid obscuring the examples described. The description is not to be considered as limiting to the scope of the examples described herein.

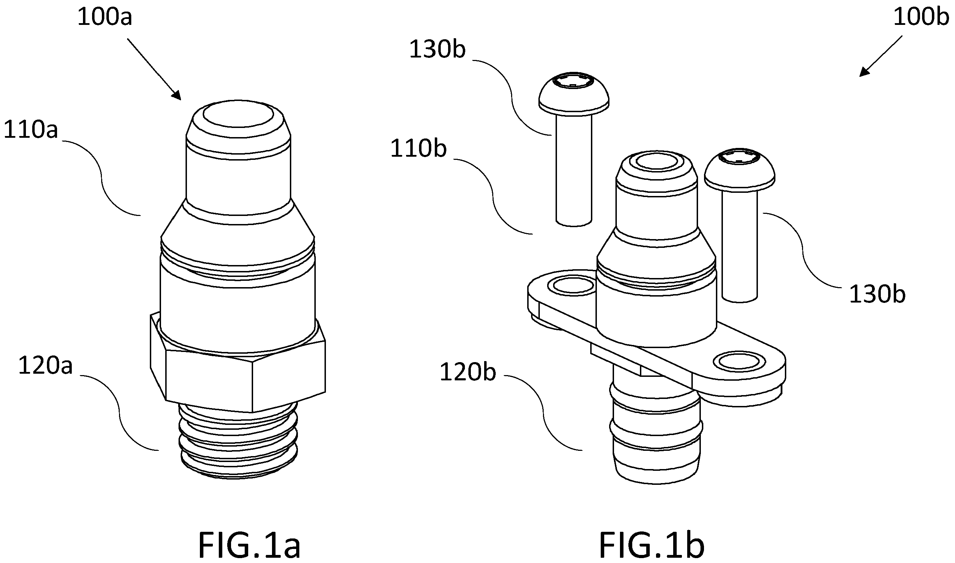

Figure 1a illustrates a connector 100a which is a screw-in type connector. In this arrangement, a first interface portion 110a is arranged for coupling with a connector on a hose side. The other interface portion 120a is configured for coupling with a device on a device side. The interface portion 120a is screwed into or twisted into, for example, a threaded bore hole receiver within the device and securely held in place to the device via the screw and thread configuration. In this arrangement, the bore hole in the device requires internal threading to allow fitting of the screw 120a for securing the connector 120a in place. Figure 1b illustrates a second type of connector 100b in the form of a screw-on connector. In this arrangement, one interface portion 110b is arranged for coupling with a connector on a hose side with the other interface portion 120b configured for coupling with a device on a device side. The interface portion 120b is pushed into, for example, a bore hole receiver within the device and securely held in place to the device via screws. In this arrangement, additional recesses, are required in order to fit the screws 130b for securing the connector 120b in place. The prior art arrangements require a high level of manufacturing effort to introduce the thread on the connector and the device and are typically made of Aluminium to maintain a preload. Clearly, the overall connection of the connector 100a, 100b into the receiver is a joint-type connection by way of interlocking and a suitable preload is required for those interacting and interlocking components. However, there are additional costs associated with the use of metal materials. The screw-on connector variant is typically made of relatively less expensive plastic however, additional costs arise due to the need for additional sockets made of metal to maintain a preload. Utilizing screws as part of the assembly process therefore results in additional installation space and effort requirements. Therefore, there are disadvantages associated with the prior art arrangements, including costs and requirements for additional components and space.

With reference to Figures 2 to 10 connector arrangements according to various embodiments of the specification are described.

Referring initially to Figures 2a to 2g, a connector 200 according to an exemplary arrangement of the specification is described. The connector 200 is a dual interface or dual plug connector. The connector 200 comprises a connector body 201 having a first interface portion 240 at a hose facing side 241 and a second interface portion 250 at a device facing side 251. The first and second interfaces 240 and 250 both comprise push-in or push-fit type connector plugs. The terms first and second plug and first and second interface are used interchangeably in the specification to refer to that portion of the connector that engages with corresponding sockets at the hose side and device side. The first and second interfaces 240, 250 each define mating interfaces of the connector for engagement with corresponding receivers or sockets. In the exemplary arrangement, the first interface or plug 240 is a hose or hose interconnector interface 240 or hose interconnector plug configured for connection to an interlocking hose connector for coupling the connector 200 with a hose, the hose being part of a fluid line. The second interface portion 250 is a device interface 250 or device connector plug configured for connection to a fluid device in a fluid circuit, for example, a heating or cooling device 550 at a socket 555 of the device.

The connector body 201 may be comprised of a plastics material or a polyamide material. In a preferred arrangement the connector body may be comprised of a nylon material. However, it will be appreciated that suitable alternative materials may be used.

The connector body 201 has a first proximal end 225 and a second distal end 220. The connector body is arranged around the central longitudinal axis (X-X). The dual interface connector 200 comprises a central passage 260 extending through the connector body 201 in the longitudinal direction (X-X) between a distal end opening 221 at the distal end 220 and the proximal end opening 226 at the proximal end 225 of the connector 200. The passage 260 defines a hollow central bore or channel extending through the connector body 201. In use, fluid may be circulated through the passage 260.

The connector 200 comprises a collar230 arranged between the first and second interface portions 240 and 250.

The connector 200 has a generally cylindrical form overall. The body 201 is arranged circumferentially around the central passage 260 and central axis (x-x). The portions of the connector 200 including the first interface 240, the second interface 250 and the collar 230 each have a generally cylindrical form. As described below, the interfaces may further include engagement features, shaped or tapered portions, and recesses arranged circumferentially relative to the body and axially along the longitudinal axis. The first and second interfaces are each formed for mating with a corresponding hose or device socket. Therefore, the dimensions and form of the interfaces will conform with those of the corresponding sockets.

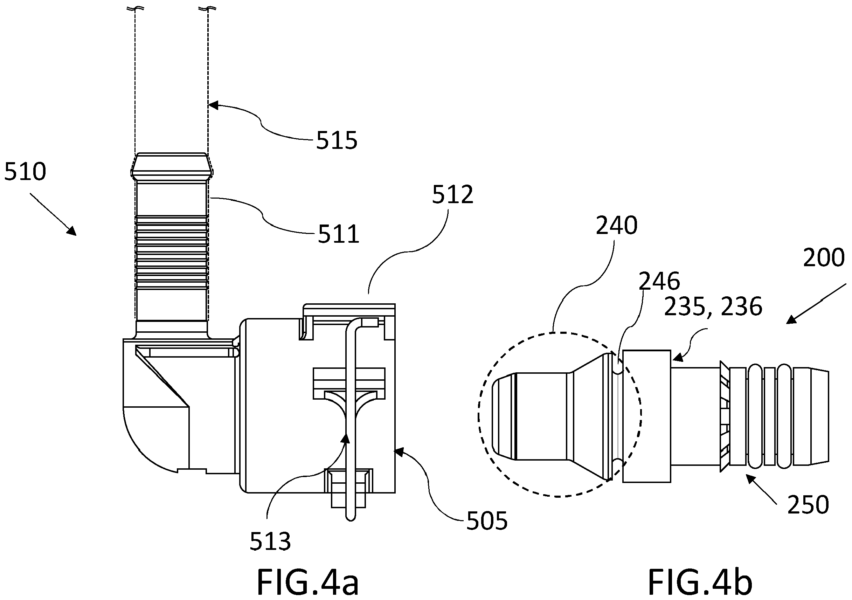

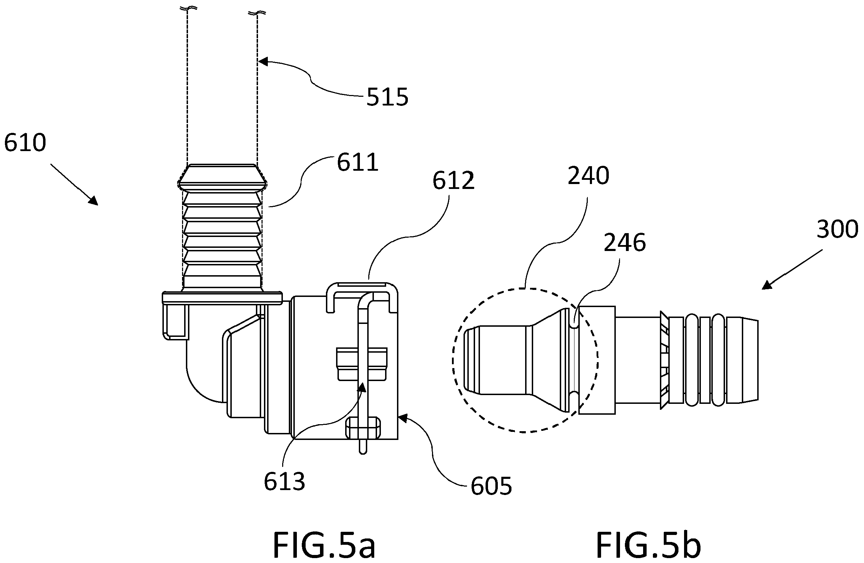

The dual interface connector 200 is configured in the exemplary arrangements of the specification for connection of a fluid line for circulation of fluid. A receiver for receiving the first interface portion may in a preferred arrangement be a receiver 505 or socket 505 of an interlocking hose connector 510 for coupling the first interface or hose interface 240 with a hose 515 as shown in Figures 4a, 4b, 5a, 5b. The device 550 also comprises a receiver 555 or socket 555 configured for engagement with the second interface namely the device interface 250 as shown in Figure 2c.

The first connector portion 240 (also referred to as the first interface 240) has an elongated body defining a plug 243 extending between the proximal end 225 of the connector 200 and the collar 230. The first connector portion 240 comprises an external mating surface 244 of generally cylindrical form and configured to be receivable in socket 505 of the interlocking hose connector 510. A recess 246 is provided between the external mating surface 244 and the collar 230. The first connector portion 240 further comprises a tapered section 248 which tapers outwardly relative to the external mating surface 244 in the direction of the recess 246.

The second connector portion 250 (also referred to as the device interface 250) comprises an elongated body defining a plug 253. The elongated body 253 extends between the distal end of the connector and the collar 230 and has a length L1. The second connector portion 250 comprises an external mating surface 254 of generally cylindrical form, and is configured to be receivable in a corresponding socket 555 of the device 550. The device socket 555 and the plug 253 comprise corresponding mating features, and conforming dimensions, and are formed to allow for an interlocking engagement. In the context of the fluid line for circulation of a fluid, the interlocking engagement is configured to provide a sealing engagement. Similarly, the coupling between the connector 200 and the hose 510 at the device side is configured to provide a sealing engagement.

As shown in Figures 2a to 2g, the device interface 250 comprises three recesses 256-1, 256-2, 256-3 formed in the external peripheral surface 254 thereof. Each recess 256 has a circumferential form. Each recess extends continuously around the device interface 250 defining a channel recessed relative to the external mating surface 254. The recesses 256 are located longitudinally or axially spaced apart from each other and spaced apart from the distal end 220 and from the collar 230 of the connector 200.

A first sealing element 290 is locatable the first circumferential recesses 256-1. A second sealing element 280 is locatable in the second circumferential recess 256-2. The first circumferential recess is located near, but spaced apart from, the distal end 220 of the connector 200 and the second circumferential recess is located between the first and third circumferential recesses. The sealing elements 280, 290 are each resilient and configured in use to sealingly engage with a corresponding portion of an internal wall 556 of the device socket 555 when the second connector portion 250 is coupled with the device 550. The sealing elements 280, 290 may be comprised of a rubber material. The sealing elements 280, 290 may comprise an O-ring type sealing element. The sealing elements may be made of an elastomer material, preferably an ethylene propylene diene monomer, EPDM, rubber.

A fastener 270 is locatable in and provided in the third circumferential recess 256-3. The fastener is located in the recess nearest to the collar 230 and spaced apart therefrom. The fastener may be comprised of a metal material, preferably stainless steel. The fastener comprises a body portion 271 having a generally annular or ring-shaped form. The fastener 270 comprises a plurality of circumferentially located protrusions 272 extending outwardly relative to the body portion 271. Referring to Figure 2b, when the fastener 270 is located in the recess 256-3, the protrusions protrude outwardly relative to the external peripheral surface 254. Overall, the form of the protrusion of exemplary Figure 2b, is similar to that of a right-angled triangle in cross-section. The inclined wall of protrusions 272 is arranged at an angle to the body of the fastener and to the peripheral surface of the connector and extends outwardly relatively to the fastener in the direction of the collar230 orwhen the interface is located in the socket in the direction of the external opening of the socket. The angle of the inclined wall assists in allowing the insertion of the connector into the receiver as the narrow end is located to the side that is being moved into the receiver. The front wall facing the collar is generally orthogonal to the external peripheral surface of the connector. The plurality of protrusions 272 are configured to engage a portion of the internal wall 556 of the socket 555 circumferentially to fasten the device interface 250 therein. The fastener 270 provides a gripping to the internal wall 556. The protrusions are resilient, and flex when the plug 253 is being inserted into the receiver and to engage with a corresponding portion of the internal wall 556 of the socket 555 with a bias.

In preferred arrangements the fastener 270 may comprise a serrated washer or a lock washer is provided integrated on the device connection plug 253, and which locks itself in the device-side socket 555 after installation and thus fixes the device connection plug 253 or the device interface 250 in place in the device side receiver or socket 555.

It will be appreciated that protrusions 272 having a different form that of Figure 2b but which provide a similar fastening or securing of the device interface in the socket may be provided.

As described above by virtue of the arrangement of the device interface 250 and the fastener 270, a secure connection is provided when the device interface 250 is received in the socket 555. The plurality of protrusions 272 extend outwardly from the external peripheral surface 254 in the direction of the internal mating surface 556 of the receiver 555 and angled outwardly in the direction of the collar 230, such that when the device interface 250 is in a connected position, the plurality of protrusions 272 create a bias in the direction of the collar 230 thereby securely fastening the device interface 250 within the receiver 555. The bias created is such that there is a resistance to displacement of the device interface 250 in a proximal direction outwards from the socket 555.

At the same time the sealing elements 280, 290 provide a dual or double seal between the distal end of the connector 200 and the socket. The sealing elements 280, 290 are configured to sealingly engage with the internal cylindrical form wall 556 of the receiver 555. The seals created are each a continuous circumferential seal that is located between the external mating surface 254 of the device interface 250 and the internal mating surface 556 of the receiver 555.

The seal or seals are the fastener may be provided integrally with the device interface.

Referring to Figure 2e, the relative diameters and radial dimensions of the features of the device interface portion 250 and the collar 230 of the connector are shown. The inner channel 260 has a diameter D4 and the collar 230 has a diameter D1. Also shown is the diameter D3 of the external peripheral surface 254 and the diameter D2 of the outer portions of the protrusions 272 of the fastening 270. The protrusions of the exemplary arrangement of Figures 2 therefore protrude by a distance D3-D2 relative to the external peripheral surface of the connector.

Referring to Figures, 2a and 2b, the radius r2 of the external peripheral surface 254 of the device interface portion 250 is substantially constant from the distal end 220 to the collar 230. The external peripheral surface comprises recesses 256. The external peripheral surface 254 may further comprise a tapered portion 257 that tapers to a reduced external diameter at the distal end 220 of the connector 200. The radius r1 between the central axis and external peripheral surface of the first interface 240 (or hose or hose interconnector interface 240) may be less than the radius r2 between the central axis and external peripheral surface of the device interface portion 250. In one exemplary arrangement, the radius r1 is around 6.2mm and the radius r2 is 6.7mm.

Referring to Figures 2e and 2f, the connector 200 may be provided with a cap 205 having an opening 206 for receiving the first interface portion 240 of the connector 200. The opening of the cap has a diameter to allow fixing to the connector 200 by friction fit. The external mating surface 244 may comprise a tapered portion 247, that tapers to a reduced external diameter, at the proximal end 225 of the connector 200. The tapered portion 247 acts as a guide and assists in the insertion of the first interface portion 240 into the cap 205.

Referring to Figure 2c, the device interface portion 250 is configured to be received within a corresponding socket 555. The device interface portion 250 and socket 555 are formed for conformity. Collar 230 comprises an end wall 235 defining a device engagement surface 236. The end wall 235 is device facing. The end wall 235 effectively further define a stop or a clamping surface. The end wall 235 is configured to abut or clamp to a portion of a corresponding engagement surface 531 of the device. The engagement surface 531 may be an external surface of the device. The engagement surface may be a portion of an outer wall 530 of the device 550 at the receiver 555. In the arrangement of Figures 2 the device engagement surface 236 of the collar is of generally circular form in cross-section and engages with a circular or ring shaped portion 531 of the outer wall 530 of the device external to and surrounding the opening of the socket 555. The end wall 235 of the collar acts as a stop and assists in the accurate location of the device interface 250 in the socket 555. It prevents over insertion but guides complete insertion to the point at which the end wall 235 of the collar 230 engages the external wall of the device 550. The collar 230 of the arrangement of Figures 2 comprises an external collar, which is located in use externally to the socket 555 when the device interface portion 250 is located therein, as illustrated in Figure 2a. The end wall 235 is configured to engage with the device at the socket when the device interface is inserted into the socket. The device 550 comprises a fluid line 520 that is arranged to interface with the connector 200. The receiver 555 has a length, L2, in the longitudinal direction (X-X) which is selected for conforming as required with the length L1 of the elongated body 253 of the device interface 250.

The device interface portion has a length L1 that spans the distance from the collar to the distal end, and radius r2 in radial cross-section extending between the central longitudinal axis and the outer surface 254. The plug-in portion of the interface has a generally straight walled cylindrical form, the radius r2 is generally constant from the proximal to distal end. In the arrangement of the figures a tapered portion 257 is provided at the distal end. The taper is provided only at the distal end - and configured essentially as a guide or locator for use when inserting the connector into a receiver. As such the tapered distal end portion is not configured for engagement with the internal wall of the receiver or active in the interactions between the seal or fastener and the internal wall of the receiver. The taper is limited in longitudinal and radial extent to the distal end of the connector.

At least two recesses are provided, spaced apart, from the collar and distal end and spaced apart from each other to accommodate a seal and a fastener. The one or more seals are located distally of the fastener.

The length L1 of the device connector portion 250 in the arrangements of Figures 2 is greater than that of the external connector 240.

The connector 200 comprises a push-in or push fit type connector for coupling with a corresponding device socket 555. The coupling is simplified by virtue of the push-in type connection. As described above with reference to previous arrangements, there is complexity and additional cost associated with providing for example a threaded connector and threaded receiver. Such connection also requires additional time including for location, alignment and fixing. The provision of a receiver or socket of a generally cylindrical form is, in contrast, relatively easier from the manufacturing point of view and also from the connection point of view. There are associated reduced manufacturing costs.

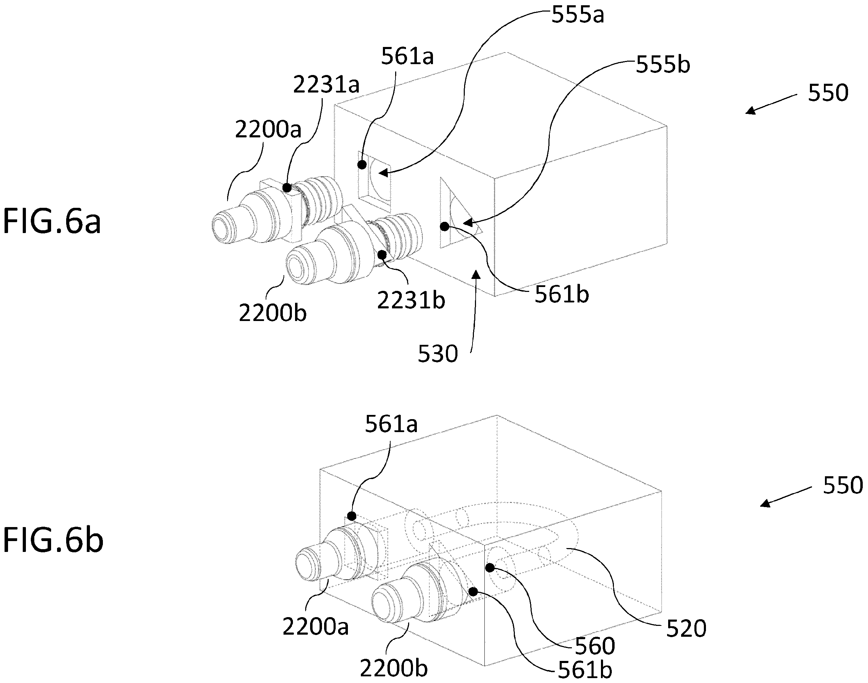

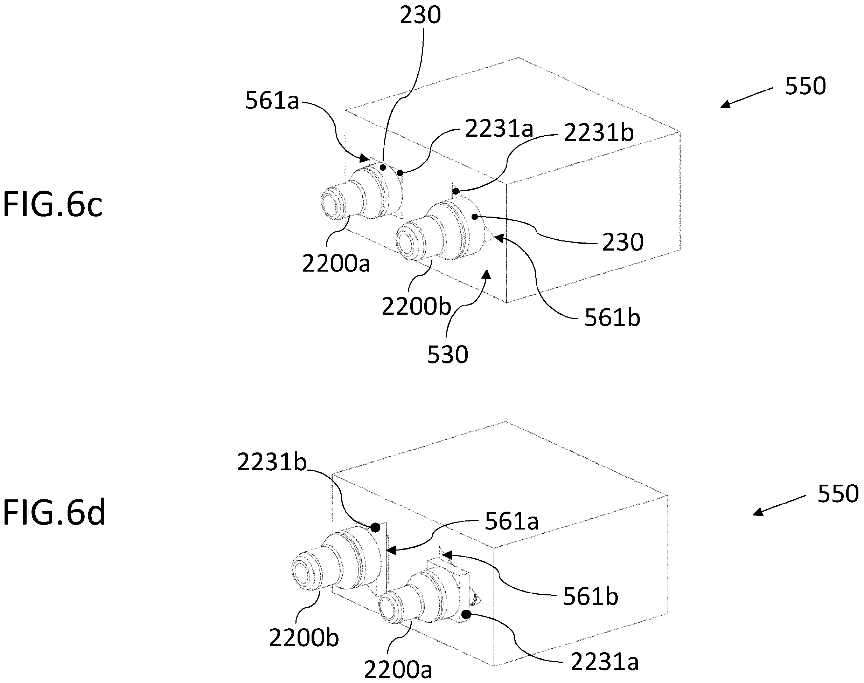

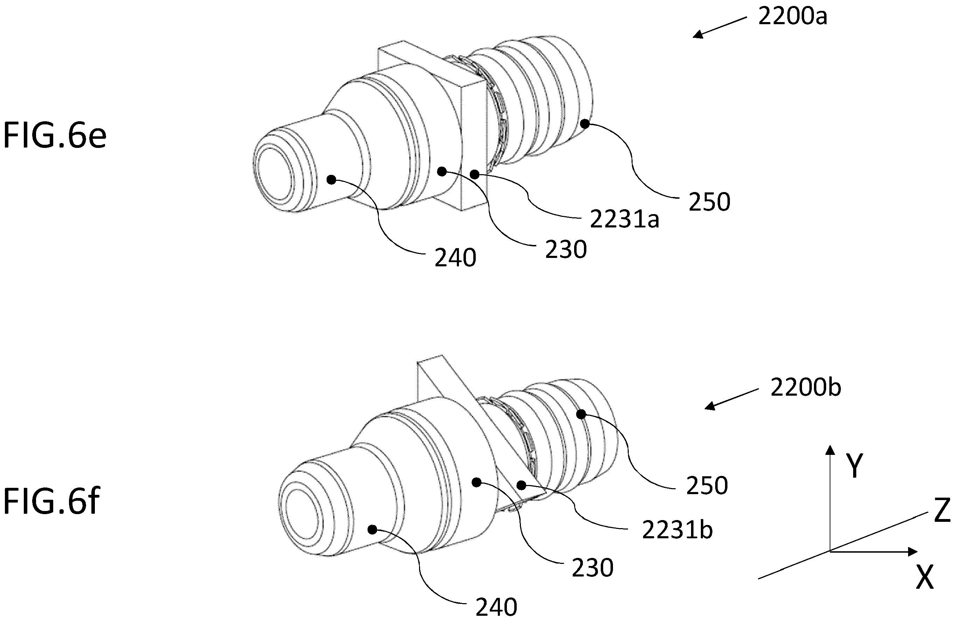

The connectors of the present specification are dual interface connectors, provided as part of or for use in a fluid line arrangement requires coupling of one or more hoses to one or more fluid device sockets. The exemplary arrangement relates in particular to those of the type for circulation of fluid between a device for example, a heating or cooling system or other fluid processing system and an externally connected device typically via pipes or hoses. In the arrangements showing the device for example figures 6, the fluid circulation is provided between an inlet and outlet of device, a cooling system in the exemplary arrangement to an external device via flow and return hoses. The fluid lines, in the exemplary arrangement considered may be for circulating a fluid via a closed loop having for example, flow from the cooling system outlet and return to the cooling system inlet via hoses and to and from a connected external device. It will be appreciated however that the connectors according to the specification and connector and socket pairs may be used in other applications.

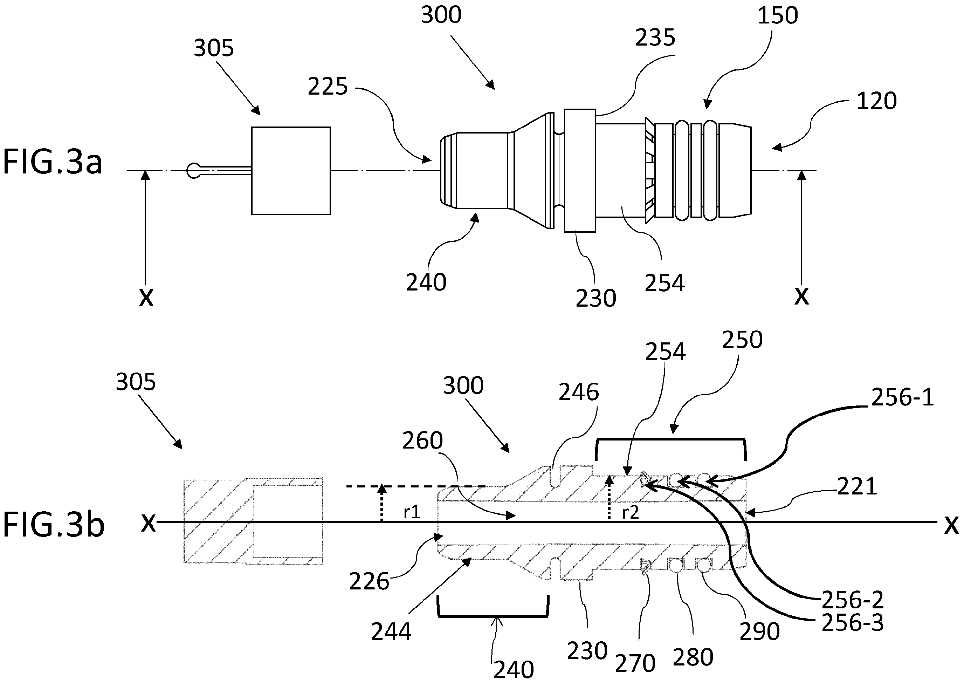

Referring to Figures 3a and 3b an alternative connector 1300 according to an arrangement of the present specification is shown. Connector 300 is similar to that of Figures 2 and the same reference numbers have been used where appropriate. The length of the first hose interface portion 240 of connector 300 is less than the length of the respective portions of the connector 200 of Figure 2. The diameter of the collar 230 of the connector 300 of Figure 3 is less than the diameter of the collar 230 of the connector 200 of Figures 2. The connector 300 comprises first and second interface portions 240 and 250 arranged about a central passage 260. The radius r1 of the connector 300 at the first interface portion may be less than the radius r2 at the second interface portion i.e. the device interface 250. Connectors of different forms are provided taking account of the different forms of the sockets and interconnectors of the overall systems. The differences in the detailed form of the portions of the connector 300 relative to connector 200 further illustrates variations possible taking account of different arrangements of sockets and connectors. However, it will be appreciated that the connector 300 is configured having a similar form to the connector 200 and for similar applications. Also the form of the connector 300 as for the other connectors of the exemplary arrangements of the specification is constrained also in view of the form of the receivers.

Referring to Figures 4a and 4b, an interlocking hose connector 510 coupled to a hose 515 and a first interface portion 511 and a second interface portion 512 for coupling to the first interface portion 240 of the connector 200. The hose 515 may be part of a fluid line connecting to an external device. The first interface portion 240 or hose interface connector portion 240 is configured to be received within a receiver 505 of the interlocking hose connector 510, the interlocking hose connector having a locking mechanism 513 that is configured to slot within the 246, thereby securing the connector 200 to the interlocking hose connector. Alternative arrangements for coupling the first interface portion 240 to the hose 515 may be provided, a key requirement is that the interface ensures a seal sufficient to allow for fluid to be circulated through the hose line.

Referring to Figures 5a and 5b an alternative interlocking hose connector 610 is shown. Illustrated is an interlocking hose connector 610 coupled to a hose 515 and a first interface portion 611 and a second interface portion 612 for coupling to the first interface portion of the connector 300. The hose 515 may be part of a fluid line connecting to an external device. The first interface portion 240 is configured to be received within a receiver 605 of the interlocking hose connector 610, the interlocking hose connector having a locking mechanism 613 that is configured to slot within the recess 246 of the connector when the connector coupled to the receiver 605 of the interlocking hose connector, thereby securing the connector 300 to the interlocking hose connector. It will be appreciated that alternative arrangements for coupling the first interface portion 611 to the hose 515 may be provided which ensure a seal sufficient for fluid to be distributed to/from the hose line to the device 550.

Referring to Figures 6a to 6f, a connector and socket coding system 2500 is described. In the coding system arrangement, the connectors and device sockets comprise corresponding coding members configured to provide a correct assignment of a connector from a set of multiple connectors to a corresponding socket. The arrangement of the specification advantageously provides a coding arrangement for providing a coded connection between at least two connector and socket pairs in a fluid line.

Referring to the drawings a first connector and socket pair 2200a, 555a and, a second connector and socket pair 2200b, 555b according to an arrangement of the present specification is shown, to illustrate the coding system. The connectors shown are similar to those of Figures 2 and 3 and similar reference numbers have been used, as appropriate.

The connectors 2200a and 2220b are dual interface connectors, provided for use in a fluid line of for example a fluid circulation system for circulation of fluid between a device for example a heating or cooling device and an externally connected device via hoses or pipes. In the arrangement shown, the fluid circulation is provided between an inlet and outlet of a cooling device to the externally connected device via flow and return hoses. The fluid, in the exemplary arrangement considered may be circulated via a closed loop having flow from the cooling device outlet and return to the cooling device inlet via hoses and the connected external device.

The cooling device comprises two sockets, namely an inlet socket and an outlet socket. Connectors 2220a and 2220b are provided for coupling each of the inlet and outlet of the cooling device to the fluid line. The first connector 2220a is configured to be received at an inlet socket 555a of the system, and the second connector 2220b at an outlet socket 555b.

Each socket 555a, 555b comprises a receiver portion 560 for receiving the device interface or second interface 2250 of a corresponding connector. Each socket further comprises a coding member portion 561, 561a, 561b. A first socket coding member of the first socket 555a is different from the second socket coding member of the second socket 555b and each socket coding members corresponds to the respective connector coding member.

In more detail, referring to Figures 6, connectors 2200a, 2200b each comprise a coding member 2231a, 2231b. The coding members are located at the proximal portion of the second interface 250 or plug 253.

In the arrangement of Figures 6, the coding members 2231a, 2231b are arranged axially between a first external collar portion 230 and the external mating surface 254 or the plug 253 of the second interface 250. The coding members are located to the proximal side of the external mating surface 254 or the plug 253. In the exemplary arrangement, the coding member is effectively arranged as a coding members collar provided distally of and adjacent to the external collar 230.

The connector coding members 2231a and 2231b define connector coding or connector keying members of a connector each define one coding member of a coding pair. The inlet and outlet sockets 555a and 555b each comprise different socket coding members 561a and 561b each defining a coding member of the relevant pair. Each connector coding member 2231a and 2231b is configured to mate with a corresponding socket coding member 561a, 561b.

It will be appreciated that the coding members may be provided at different axial locations of the second interface or the socket receiver, in any arrangement, the location of the coding members will be selected for correspondence.

The first connector coding member 2231a and corresponding first socket coding member 561a pair, both coding members of the pair, are formed for conformity and to mate with each other. The socket coding member 561a is formed recessed relative to the outer wall 530 of the system at a proximal opening portion of the socket 555. The first connector coding member 2231a is configured to be receivable at the socket having a corresponding coding member 561a. When the connector and socket are connected any external collar 2230 remains external to the socket. The end wall 235 may, depending on the form of the external collar and coding member, abut the external wall 530 of the system 550 adjacent or about the opening of the socket. Coupling between the connector and device socket by the coding arrangement is limited to one interface of the dual interface connector and depending on the form of the coding member may further be configured to provide coupling at predefined orientations of the connector relative to the socket by virtue of the arrangement of the coding system.

In the drawings, each (connector and socket) first coding member comprises a generally square shaped form in lateral cross-section and each (connector and socket) second coding member comprises a triangular shaped form in lateral cross-section. The drawings show exemplary coding members. However, it will be appreciated, that the first coding member pairs (connector and device) and second coding member pairs (connector and device) may be of any suitable form, including other geometric forms. The geometric forms have been found to provide a good visual and tactile guide and feedback as to conformity of non-conformity of the components as they are brought into alignment. Each coding member of the first coding member pair and the second coding member pair has conforming mating features to allow coupling of the correct connectors and sockets and to prevent coupling of the incorrect connectors and sockets. The visual guide, by the form of the coding member, also allows a user to distinguish a connector from another including in the case where connector plug portions of the different connectors are similar - for example connectors (200) according to arrangement of the present specification are push-in or push fit connectors that may be provided without variant forms (different diameters/length etc.) of the plug portions as different connector can be distinguished by the different coding members.

Referring back to the drawings Figures 6a to 6f show different stages in the mating of a connector and socket. In Figure 6a a first connector 2200a and a second connector 2200b each having a respective first coding member 2231a, 2231b. The device 550 is shown having an external wall 530 and two receivers 555a, 555b configured for receiving a respective connector. In the arrangement shown, the connector 2200a is positioned adjacent the receiver 555a and the connector 2200b is positioned adjacent the receiver 555b. Each of the connector coding members 2231a, 2231b is aligned with their respective socket coding members 561a and 561b.

Figure 6b provides a transparent view of the device 550, for example a cooling device, after the connectors 2200a and 2200b have been received into the receivers 561a and 561b and the connector coding member 2231a is mated with the corresponding socket coding member 561a at a proximal portion of the receiver 555a. A fluid channel 520 is shown within the device 550 for distributing fluid to and from the connectors 2200a and 2200b. One connector, for example connector 2220a of the connector pair 2200a, 2200b may be located at an inlet for return of fluid from a hose pipe while the other connector 2200b may be an outlet connector for distributing fluid from the device.

Referring to Figure 6c the device 550 is shown after the connectors 2200a and 2200b have been received into the receivers 561a and 561b and the first coding member 2231a mated with the corresponding first socket coding member 561a of the device receiver 550. A proximal end of the first coding members 2231a, 2231b may be flush with the outer wall 530 of the device 550 after being mated with the socket coding members 561a, 561b of the device 550. The end wall 235 of the collar 230 of the connector 2200b for example, see the end wall 235 previously described, may abut an outer wall 530 of the device 550 at the receiver 555b. The wall 235 is configured to act as a stop and to assist in the accurate axial location of the second interface portion 250 in receiver 555.

Figure 6d illustrates a situation where the coding member prevents an incorrect coupling of the connectors to the non-matching receivers. As connector 2200a comprising first coding member 2231a is shown in proximity to receiver 555b having coding member 561b. The coding members do not conform. The socket coding member 561b has a shape and form that is different to that of the connector coding member 2231a. In this way, the connector is prevented from being inserted into or mating with the second coding member 561b. The user obtains feedback that the connector 2220a is not the one configured for connection to receiver 555b. The user is guided to retry the coupling of the alternative connector to the receiver 555b. Similarly, connector 2200b having a second connector coding member 2231b is shown as an attempt is made to couple it into a receiver having a first socket coding member 561a.

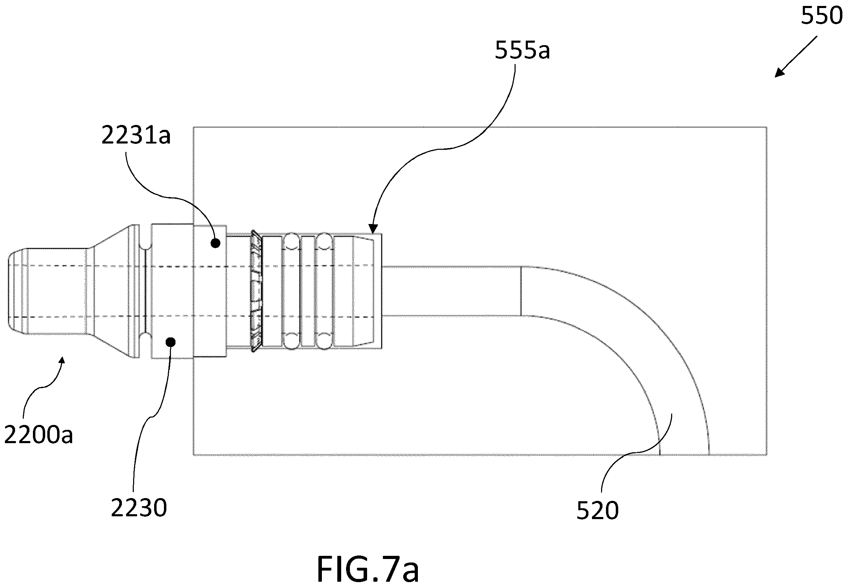

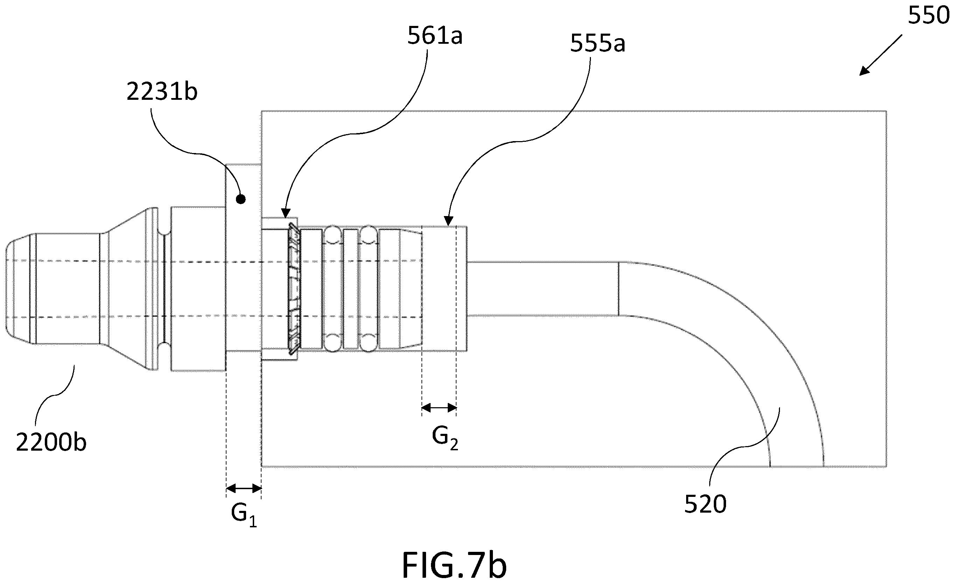

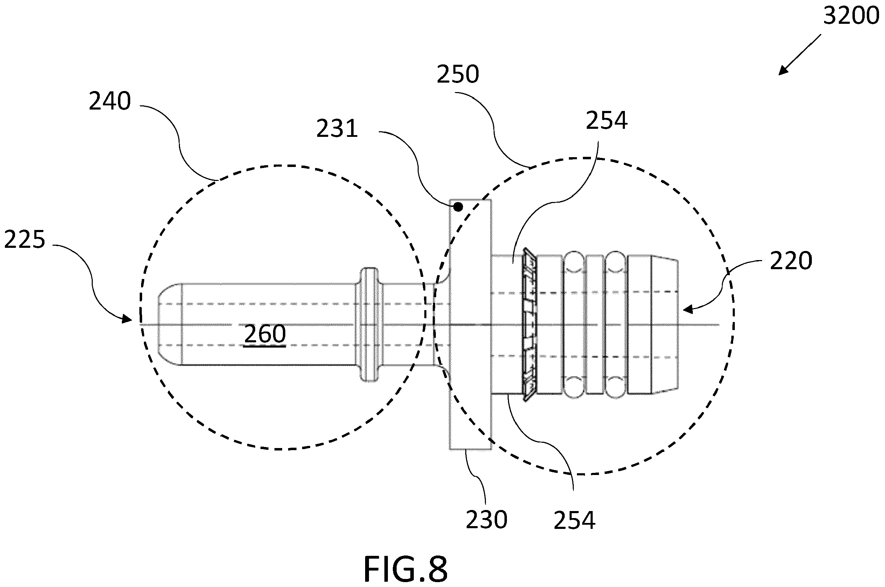

Figures 7a and 7b illustrate views of a 550, in the exemplary arrangement comprising a cooling device having one or more sockets or receivers 555 and connector 2200a. Figure 8a shows the connector 2200a when received into the correct or conforming receiver 555a. In this arrangement, the first coding member 2231a is mated with the respective corresponding first socket coding member 561a. In this arrangement, the first connector coding member 2231a is correctly mated with the first socket coding member 561a of the device 550, both of the coding members having a shape and form that matches and conform thereby supporting correct connection. Figure 8b illustrates an arrangement in which an attempt is made to mate a second connector 2200b having a second connector coding member 2231b with a first socket coding member 561a of the device 550. The socket coding member 561a, has a different shape and form to that of the connector coding member 2231b of the connector 2200b. In this way, it is identified that an attempt is being made to connect two non-matching coding members. Insertion of the connector 2220b into socket 555a is prevented.

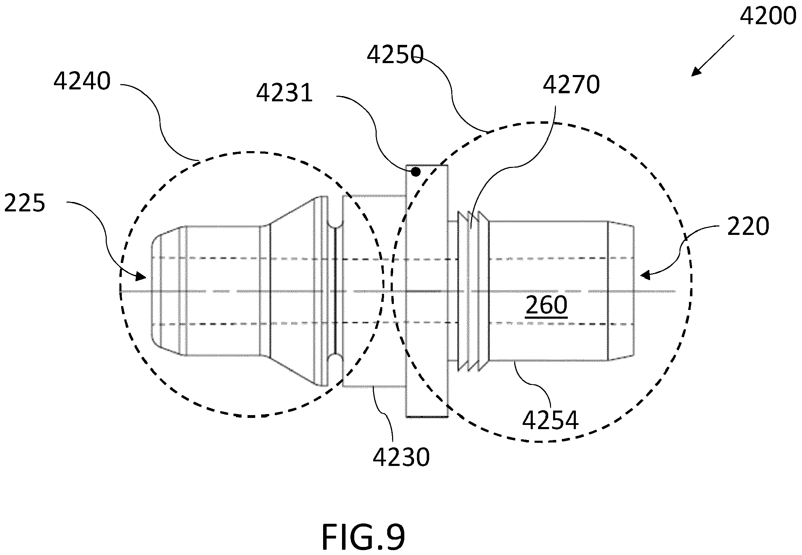

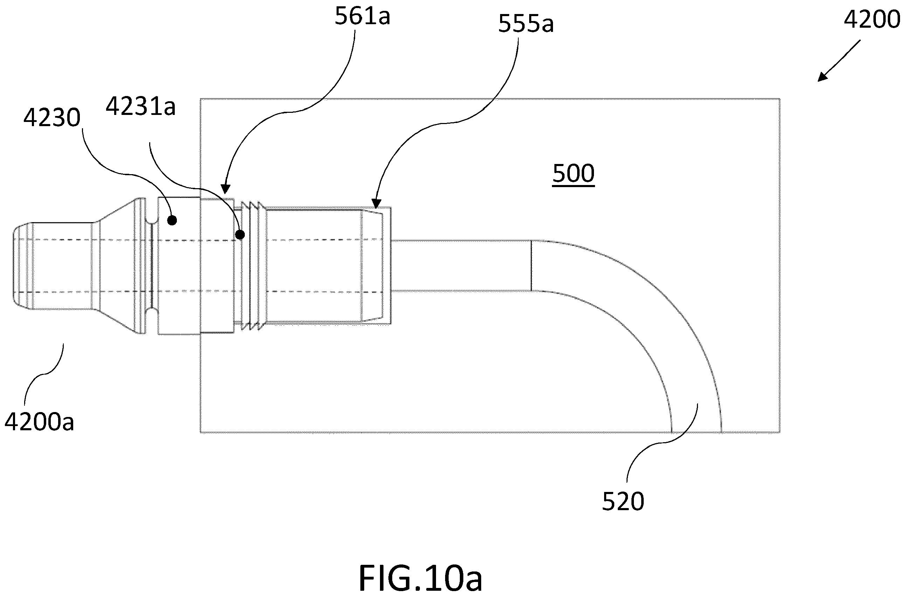

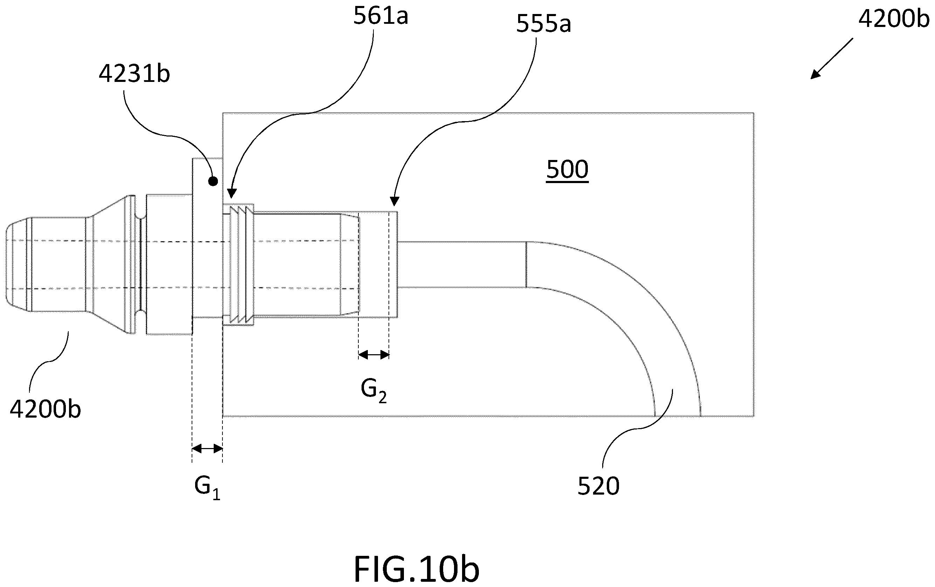

Referring to Figures 9 and 10 two alternative connectors 3200 and 4200 are shown. On a general level, the form and features of these connectors are similar to those of Figures 2 and 3 and the same reference numbers have been used where appropriate.

Referring to Figure 9 dual interface connector 4200 comprises a fastener 4270, the fastener is located at a proximal end of the device connector 4250 and is configured to extend outwardly relative to an engagement surface 4254 of the device connector to engage with an internal engagement surface of a socket of a device 550. The device connector and socket are formed for conformity for mating. The fastener 4270 may in a preferred arrangement also provide a circumferential seal between the socket and the device connector 4250. A collar 4230 and coding member 4231 are also provided.

Referring to Figure 10a, the connector 4200a is shown correctly inserted into and engaged with a corresponding receiver. The connector coding member 4231a is shown received in and engaging with a corresponding device socket coding member.

Referring to Figure 10b, connector 4200b is shown not engaged with a receiver. Clearly the coding member 4231b of the connector 4200b does not correspond with the coding member of the device socket. The user is prevented from making an incorrect assignment and connection. The coding member 4231b is not receivable in and does not mate with the socket shown. The plug cannot be fully engaged with the receiver 555a and as shown, there are gaps G1 and G2 between the engagement wall of the collar and the external wall of the device and between the distal end of the receiver and that of the plug.

The arrangements of the specification provide advantages over previous arrangements. First of all the arrangements provide for improved accuracy in use of the system and ease of use. In previous arrangements, problems with coding on connecting plugs in fluid circuits include the expense and costs associated with production, and further requirements for storage and documentation due to the requirement to provide variants. For example, in a previous system of type similar to that described in the present specification, if two or more connecting plugs are used on one device in fluid circuits, they are usually coded by providing different dimensions on the hose side. This means that each connector on the hose side can be assigned to the correct connector on the device side (similar to the device of the arrangements of the present specification). Coding on the device side usually requires the generation of variants for the sealing and fastening elements on the connecting plugs and increased investments and inputs for different receiving contours to be provided on the device. Coding is therefore often avoided. This however in turn increases the risk of incorrect positioning can then be high with manual assembly.

The arrangements of the present specification are directed to a device side coding that does not require of variants for the sealing and fastening elements of the device side interfaces or plug connectors. Further advantags arise from the provision of geometric coding in the case that the coding is exposed or visible on the connector. Sealing or fastening elements on the system side can therefore remain the same for the different connectors as the user has the benefit of the coding arrangement to ensure correct asignment of corresponding coding members, and correct alignment and correct connections. Therefore the requirements for variants that arose with previous system are reduced and the arrangement provides an easy to use system at reduced costs and reduced manfacturing complexity.

Advantages include the folllowing:
- reliable assignment can then be made before assembly and the correct or incorrect positioning of the connector can be visually recognized.
- A fastener for example a serrated washer/ lock washer is provided integrated on the connector plug, the fastener is configured to lock itself in the device-side socket after installation and thus fixes the connection plug.

The arrangements of the specification provide the following further advantages:
- Saving of installation space, since it not necessary to make space available for the movement of the screwdriving tool, as the specification provides push- in or push fit connectors.
- Simplified mounting contour in the device (socket having a cylindrical form internal wall instead of a thread receiver). The receiver portion of the socket of the arrangements of the specification is a smooth walled receiver and does not require any specific features.
- installation is also simplified in that the connector is inserted to a stop (push-in/push-fit arrangement), there is no requirement for consideration of torques during assembly as with previous arrangements.

The simplified form of the connector 250 is advantageous from the points of view of manufacture and use. The connector 250 has essentially a uniform generally cylindrical form, two or more recesses 256 are provided recessed in the external wall. The external wall 254 does not comprise a complex form and a complexity of different features such as shoulders or tapers along the longitudinal extend thereof. Although as described the distal end 257 distal of the one or more seals may comprise a taper from the external radius r2 (to generally around > 90% of r2).

## Claims

1. A connector (200) for connection to a fluid heating or cooling device (550) comprising a socket (555), the connector comprising:
a connector body comprising:
a channel (360) defining a fluid pathway between an inlet and an outlet;
a plug (250, 253) receivable in the socket (555) of the device and formed for conformity with the socket (555) and for secure coupling thereto, the plug (250) comprising an elongated body portion;
a collar (230) arranged at a proximal end of the plug (250);
wherein the plug (250) comprises:
a seal (280) configured to engage with a corresponding portion of an internal wall (556) of the device socket (555) to provide a sealing engagement therebetween, when the plug is coupled to the socket;
a fastener (270) is configured to engage with a corresponding portion of the internal wall of the device socket (556) to securely fasten the plug at the correct location in the device socket; and
wherein the collar (230) is configured to engage with the device (550) to locate the plug (253) relative to the socket (555);
wherein the connector (200) comprises a first connector coding member (2231) formed to conform with a corresponding first device coding member (561), wherein the device coding member is formed at a portion of the socket (555).

2. The connector of any of claim 1, wherein the seal (280) and the fastener (270) are integrally formed with the plug (250, 253).

3. The connector of any preceding claim, wherein the seal (280) comprises one or more sealing elements, located spaced apart, each sealing element configured to sealingly engage with a corresponding portion of the internal wall of the socket.

4. The connector of any preceding claim, wherein the device comprises a fluid cooling or a fluid heating device (550) of a fluid circuit and wherein the connector is configured to connect an external device via a hose or pipe to the fluid cooling or heating device.

5. The connector of any preceding claim, wherein the socket (555) of the device (550) comprises a recessed channel (556) of generally cylindrical form, the internal peripheral surface of the channel defining a mating surface for mating with the external peripheral surface (254) of the plug (250) defining the device interface of the connector.

6. The connector of any preceding clam, wherein the collar (230) comprises an external collar having a device engagement surface (235) and wherein the device engagement surface (235) is arranged to engage with a corresponding engagement surface (531) of the device (550) when the plug (250) is located in a corresponding socket (555).

7. The connector of claim 1 wherein the device coding member (561) is formed at an opening portion of the socket (555).

8. The connector of any preceding claim, wherein the collar (230) comprises the connector coding member (2231).

9. The connector of any preceding claim, wherein the coding member (2231, 561) comprises a geometric form and is located to provide a visual or tactile guide to the user to allow a user to distinguish a connector (200) from a set of connectors.

10. A connector and socket pair coding system for providing a coded connection between one or more connectors (200, 1200, 2200) and one or more device sockets (555) of fluid heating or cooling device in a fluid circuit, each connector (200, 1200, 2200) being configured for coupling at a corresponding device socket for circulation of fluid in the fluid circuit via the device,
each connector (200, 1200a, 1200b, 2200a, 2200b) comprising device connector plug (250, 253) for coupling to a socket of the device;
each device socket (555a, 555b) comprising a receiver for receiving a device connector plug and a socket coding member, the socket coding member (561a) of a first socket being different from a socket coding member (561b) of another socket;
wherein a first connector (1200a) comprises a device connector plug (250) and a first connector coding member (2331a) corresponding to the first socket coding member (561a) of the first socket (555a), for mating thereto;
the coding system configured such that each corresponding socket and connector comprises corresponding connector and socket coding members configured to provide correct assignment of each connector to the corresponding socket only.

11. The connector and socket coding system of claim 10, wherein the fluid circuit between an externally connectable device and the fluid heating or cooling device (550) is a closed loop fluid circuit, and the first socket (555a) comprises a device inlet for receiving fluid returned from the externally connectable device and the second socket (555b) comprises a device outlet for circulating fluid from the device.

12. The connector and socket coding system of claim 10 or claim 11, wherein each device socket (555) comprises a distal receiver portion (556) having a generally cylindrical form for receiving a corresponding device connector plug (250, 253), wherein the device connector plug (253) is configured for engagement with the receiver portion in a push fitting engagement.

13. The connector and socket coding system of any of claims 10 to 12, wherein the device connector plug (253) is configured to sealingly engage with the receiver, the device connector plug comprising one or more seals that are configured to provide a circumferential seal between the device connector plug and the receiver.

14. The connector and socket coding system of any of claims 10 to 13, wherein the device connector plug (253) comprises a fastener (270) for providing a circumferential fixing engagement between the device connector plug and the receiver, the fastener comprising a resilient fastener configured to exert a biasing force against the receiver.

15. A fluid heating or cooling device and a dual interface connector system configured for connection in a fluid circuit to provide circulation of a fluid in a loop between an externally connectable device and the heating or cooling device, the circulation of the fluid including flow from an outlet of the heating or cooling device to the externally connected device and return to an inlet of the heating or cooling device via hoses or pipes,
the fluid heating or cooling device comprising a device inlet socket and a device outlet socket, each socket configured to receive a corresponding device connector plug of a dual interface connector as claimed in any of claims 1 to 9, for connection of an externally connected device to the device inlet and device outlet;
wherein each socket comprises a receiver having an internal peripheral surface of generally cylindrical form defining a mating surface for mating with an external peripheral surface of the device connector plug, each device connector plug comprising a seal and fastener configured to engage with the socket to provide a sealed and securely fastened connection therebetween when the device connector plug is received in the socket;
wherein the inlet and outlet sockets each further comprise a socket coding member, the socket coding member of the inlet socket being different from the socket coding member of the outlet socket, and wherein each of the corresponding connectors has a connector coding member corresponding to the socket coding member of the inlet or the outlet socket respectively, the socket and connector coding members being configured to provide a correct assignment of connectors to the inlet and outlet sockets.
